Europäisches Patentamt

European Patent Office

Office européen des brevets

(11) Publication number: **0 198 624**
**A1**

(12) **EUROPEAN PATENT APPLICATION**

(21) Application number: **86302326.3**

(22) Date of filing: **27.03.86**

(51) Int. Cl.⁴: **H 02 H 9/04,** H 01 L 45/00

(30) Priority: **29.03.85 GB 8508305**

(43) Date of publication of application: **22.10.86** Bulletin 86/43

(84) Designated Contracting States: **AT BE CH DE FR GB IT LI NL SE**

(71) Applicant: **RAYCHEM LIMITED, Rolls House 7, Rolls Buildings Fetter Lane, London, EC4 1NL (GB)**

(72) Inventor: **Wright, Martin Andrew, 27 Medgbury Road, Swindon Wiltshire (GB)**

(74) Representative: **Dlugosz, Anthony Charles et al, Raychem Limited Intellectual Property Law Department Faraday Road, Dorcan Swindon Wiltshire (GB)**

(54) **Overvoltage protection device.**

(57) A circuit protection device for protecting an electrical circuit from a voltage transient comprises a semiconductor threshold switching element (52, 54, 55) connected or arranged to be connected between a current carrying line and earth, and a capacitor (51), preferably having a capacitance of 0.1 to 2 microfarads connected in series with the switching element between the switching element and earth.

In a preferred form of the invention, a number of threshold switching elements that are each connected to a common capacitor located between the switching element and earth.

The device enables semiconductor threshold switching materials to be used for circuit protection without the low frequency compounds of the pulse or direct currents in the lines from latching the switching material in its low resistance state.

## Overvoltage Protection Device

This invention relates to circuit protection devices and especially to devices for protecting electrical circuits from voltage transients that are caused by an electromagnetic pulse, e.g. lightning, and also the transients that are caused by electrostatic discharge.

Electrostatic discharge and electromagnetic pulses can all induce very high currents and voltages on cables and structures such as aeroplanes and ships, which can penetrate the electrical systems and damage them, either causing hardware damage such as semiconductor burnout, or electronic upset, e.g. transmission loss or loss of stored data. As semiconductor technology advances, the energy needed to cause such damage becomes less.

Electrostatic discharges are extremely fast discharges from a capacitor such as a human body. These discharges, because they can be so local, present an extreme threat to the individual electronic component. The magnitude of the threat is illustrated by reference to IEC Technical Committee TC65, WG4 draft specification or the SAE-AE-4 proposed specification on ESD. In these documents the maximum threat is a double exponential pulse of rise time 5 nanoseconds with a 30 nanosecond fall time. The peak voltage is given as 15,000 volts with a current of 70 amps. The energy storage capacitance is given as 150 pico farads giving a maximum energy of 33 millijoules.

Induced electrical transients caused by lightning represent a threat to electrical/electronic equipment especially in aerospace vehicles.  The characteristics of the induced pulses are best described in the SAE AE4L Committee Report AE4L-81-22.  Test Wave Forms and Techniques for Assessing the Effects of Lightning -Induced Transients.  This specification describes the idealised versions of the lightning stroke waveform and of those which occur when equipment cables are excited by the EM environment produced.  The specification specified a range of transients which may be produced during normal operation.  The waveforms expected on each line depends on a number of factors but the two basic types are (waveform 3) with a frequency of between 1 and 10 MHz, a rise time of 45 nanoseconds and a peak current of 24 amps.  The alternative wave form (Wave Form 4A) is a decaying exponential with a rise time of 100 nanoseconds and a width of 2 microseconds with a peak voltage of 300 volts and peak current of 60 amps.

The most severe threat to electrical and electronic equipment is the electromagnetic pulse although all effects can generate large voltage or current spikes with very short rise times.  The exact characteristics of the pulse are complicated although a typical pulse will exhibit a field strength of about $10^5$ $Vm^{-1}$ with an accompanying H field intensity of 130 $Am^{-1}$ (based on free space impedance of 377 ohms), a pulse width of a few microseconds and a rise time of a few nanoseconds. In general damaging amplitudes in the pulse occur within the frequency range of 10KHz to 100MHz.

It has been proposed to use certains materials, for example certain chalcogenide glasses, in the formation of devices for protecting electrical circuits, for example as described in U.S. patent No. 3,271,591 and 3,343,034 to Ovshinsky and, U.S. patent No. 3,436,601 to Dyre, the disclosures of which are incorporated herein by reference. Some of these chalcogenide glasses may be used to form "threshold" devices by which is meant devices that will change from a high resistance state to a low resistance state on application of a high voltage, called the the threshold voltage, but which will remain in their low resistance state only for as long as a small "holding" current is maintained. Other glasses can be used to form "memory" devices which will change from a high resistance state to a low resistance state on application of a high voltage and which will then remain in their low resistance state, even when no voltage is applied, until an appropriate, different, voltage pulse is applied. Only threshold devices are considered here in the manufacture of circuit protection devices since it is desirable for the device to return to its normal operating state as soon as any transient has passed.

Chalcogenide glass materials have been considered for use as circuit protection devices in view of a number of desirable properties, for example they can switch from their high resistance state to their low resistance state in a very short time, e.g. in less than 1 nanosecond, and the electrical resistance of their high and low resistance states can differ by two, three or even by four or more orders of magnitude. However, these materials, and other switching materials, can suffer from a number of disadvantages. For example, we have found that even though a switching device may be formed from a threshold material, it may easily become permanently electrically conducting, with the result that the protection device must be replaced or reset before the circuit can be used.

The present invention provides a device for protecting an electrical circuit from an electrical surge, which comprises a semiconductor threshold switching element that is connected, or arranged to to be connected, between a current carrying line of the circuit and earth, and a capacitor connected in series with the threshold switching element between the threshold switching element and earth.

We have observed that the problems of the previous proposals are due, at least in part, to the fact that after the transient has passed, the normal direct currents that may occur in the circuit can hold the switching element in its low resistance state indefinitely, and that very low frequency alternating current power lines in the circuit may hold the element in its low resistance state for sufficient time for the material to "latch" i.e. to adopt memory characteristics and thereby cause the device to remain permanently in its low resistance state.

According to the present invention, these problems are overcome by the provision of a capacitor in series with the switching device, between the switching device and earth (the term "earth" in this context including any structure having an appropriate shape and/or capacity so that it can absorb charge generated by the transient, and includes for example connection to chassis of equipment and the like in vehicles such as aircraft). The required capacitance of the capacitor will depend on a number of factors including the material from which the switching element is formed, the nature of the transient against which the protection is desired, and the intended use of the circuit. For example, in order to protect an electrical circuit against electrostatic discharge, a capacitance of at least 1 nanofarad is preferred, and especially at least 10 nanofarads. For protection against other threats, for example as described by H.R. Philipp and L.M. Levinson in J. Appl Phys. 52(2) February, 1981 pp. 1083 to 1090, the disclosure of which is incorporated herein by reference, the capacitance may need to be larger, e.g. at least 30 and preferably at least 100 nanofarads. A capacitor of this size will allow all transients having a frequency spectrum above about 1 MHz to pass to earth and so allow the device to protect the circuit from the transient. Preferably the capacitor has a capacitance of not more than 2, more preferably not more than 1 and especially not more than 0.5 microfarads. The use of a capacitor of less than 2 microfarads and particularly one of less than 1 microfarad has the advantage that the switching device is itself protected by the capacitor against damage by low frequency components of the transient. On the basis of observations made, it appears that certain forms of threshold switching elements may require less electrical energy to latch them in their low resistance state at low electrical frequencies (e.g. less than 100 KHz) than at higher frequencies. Thus, many devices that exhibit acceptable energies to latch at frequencies of about 10 MHz would, in fact, latch in their low resistance state when subjected to a voltage transient due to the low frequency components of the transient if no such capacitor were provided. Any such low frequency components of the transient that are not passed to earth by the switch can easily be filtered out of the electrical circuit by conventional means with no loss to the signal carried by the circuit.

The devices may be incorporated in an electrical circuit in any suitable position, normally being connected between a current carrying line and earth, and, of course, more than one such device may be employed in the electrical circuit. The devices are conveniently incorporated in other electrical components for example electrical connectors, in which case the device will usually be connected between a current carrying element of the device and a terminal or other part of the device to be earthed e.g. a conductive housing or an earth line. The device should be arranged so that the entire pulse passes through the switch and the capacitor, i.e. by arranging the device so that no current carrying paths are connected in parallel with the capacitor or switch.

In many devices according to the invention, each switching element will be connected to a separate capacitor, and in such devices it may be convenient to form the capacitor and the switching element as a single unit. For example, if the capacitor has a terminal that is substantially flat, the material from which the switching element is formed may be deposited on the terminal either directly or after the terminal has been suitably prepared e.g. by the provision of a deposited layer of electrode material for the switching element for instance molybdenum. After the switching material has been deposited a second electrode layer is deposited, optionally followed by one or more further layers e.g. to improve solder adhesion.

In other devices, however, a single capacitor may
be connected to a number of switching elements. For
example a connector may be provided with a switching
element for each current carrying line and all the
switching elements may be connected to earth via a common capacitor. Since the capacitor will usually have
significantly larger dimensions than any of the
switching elements, such an arrangement offers a
substantial reduction in size. It was considered that
if two lines in such a device carried direct currents
and were at different potentials, then if both the
lines simultaneously experienced the transient, as
might well be the case, thereby switching both their
respective switching elements to a low resistance
state, the switching elements may be latched in their
low resistance state by a direct current flow from one
line to the other, since there would be no capacitor in
series between the current carrying lines. However, we
have observed that, in general, no such latching
occurs. It is believed that the absence of latching is
due in part to the fact that, for signal lines the
system impedance is so high that the current flow between the lines is usually too small to retain the
switching elements in their low resistance state, and
in part because in order for the elements to latch due
to current flow between the lines, the current flow
through one of the switching elements must be reversed
as the transient subsides, and that switching element
will revert to its high resistance state as the instantaneous current reaches zero during the current reversal.

Although in most instances the device will revert
to its high resistance state as soon as the transient voltage has subsided, it is possible for the device to be forced into a permanent low resistance state, for example if the voltage transient is unduly large or if a number of rapid transients are experienced. Whether or not the device will become permanently conductive depends on the amount of energy absorbed by the device from the transient. In some applications, for example in some ground installations, it may be desirable for the protection device to fail in this way, that is to say, so that the equipment is still protected against transients but will not function until the protection device is replaced. In other applications it may be desirable for the device to fail in a high resistance (open circuit) state so that the equipment will carry on functioning although unprotected from subsequent transients. Thus the device may includes means, connected in series with the switching element, that will exhibit a high resistance if the switching element becomes permanently electrically conducting. Preferably such means will exhibit such a high resistance if the switching element becomes permanently conductive that the circuit between the current carrying line and earth is effectively broken, such means including a fuse or switch. In the case of d.c. circuits or circuits carrying very low frequency alternating currents, the device may be connected between the capacitor and earth although it is preferred, especially for d.c. circuits, for the device to be connected between the current carrying line and the capacitor so that the capacitor is isolated from the line in the event that the switching element fails.

Preferably the material forming the switching element has a turn-on time of not more than 1 nanosecond, and a turn-off time of not more than 10 microseconds especially not more than 1 microsecond. Also, as explained in our copending British Patent Application entitled "Circuit Protection Device" and filed on even date herewith (Agents's Ref. RK268) it is preferred for the material to have a critical switching field strength in the range of from $10^4$ to $10^5$ Vcm$^{-1}$ and a resistivity in its high resistance state of at least $10^7$ ohm cm. Furthermore, preferred switching element materials will have a latching energy of at least 2000, preferably at least 4000 and especially at least 10,000 Jm$^{-1}$ (joules per metre of the element thickness) and exhibit a figure of merit of at least 10 and especially at least 20 kgm$^3$s$^{-2}$A$^{-1}$, where the figure of merit is defined as:

$$\text{figure of merit} = \frac{E_L \cdot \rho_{\text{off}}}{V_{\text{th}} \cdot \epsilon_r}$$

in which $E_L$ is the energy required to latch the material in its low resistance state (measured in joules per metre of thickness);

$\rho_{\text{off}}$ is the resistivity of the material in its high resistance state (measured in ohm metres);

$V_{\text{th}}$ is the threshold field strength of the material (measured in volts per metre); and

$\epsilon_r$ is the dielectric constant of the material.

The switching element is preferably formed from a chalcogenide glass, by which is meant a glass formed from one or more elements of group VIB of the periodic table (IUPAC 1965 revision) together with one or more elements of group IVB and/or VB and optionally IIIB for example as described in U.S. Patent No. 3,271,591 to Ovshinsky. Preferred chalcogenide glasses, which can be used to form elements having the preferred properties mentioned above are described in our copending Application entitled "Circuit Protection Device" mentioned above. These glasses comprise germanium, selenium and arsenic optionally together with minor amounts of other materials. Preferably the glasses comprise:

    (a)   5 to 42 atomic % germanium;
    (b)  15 to 75 atomic % selenium; and
    (c)  10 to 65 atomic % arsenic;

in which the proportions of (a), (b) and (c) (based on the total molar quantity of (a), (b) and (c) but excluding any optional additional materials) add up to 100%.

Preferably the composition contains not more than 35 atomic % germanium, more preferably not more than 30 atomic % germanium, and especially not more than 25 atomic % germanium. Also, the composition preferably contains at least 20 atomic % selenium and especially at least 30 atomic % selenium but preferably not more than 70 atomic % selenium and especially not more than 60 atomic % selenium. The composition preferably contains at least 20 atomic % arsenic and especially at least 25 atomic % arsenic, but especially not more than 55 atomic % arsenic. Thus the composition preferably comprises:

    (a)   5 to 30 atomic % germanium;
    (b)  20 to 70 atomic % selenium; and

(c)   20 to 60 atomic % arsenic,

and most preferably comprises:

(a)    5 to 25 atomic % germanium;
(b)   30 to 60 atomic % selenium; and
(c)   25 to 55 atomic % arsenic.

All the proportions of the components (a), (b) and (c) are based on the total molar quantity of (a), (b) and (c) alone and total 100%.

Several embodiments of the invention will now be described by way of example, with reference to the accompanying drawings, in which:

Figure 1 is a side view, partly in section, of a BNC coaxial connector that incorporates a circuit protection device according to the invention;

Figure 2 is a side view, partly in section, of a flat cable mass termination connector and wafers that incorporate a circuit protection device according to the invention;

Figure 3 is an enlarged view of part of the connector shown in figure 2;

Figure 4 is a perspective view of one of the wafers shown in figure 2; and

Figure 5 is a schematic view of an individual circuit protection device according to the invention.

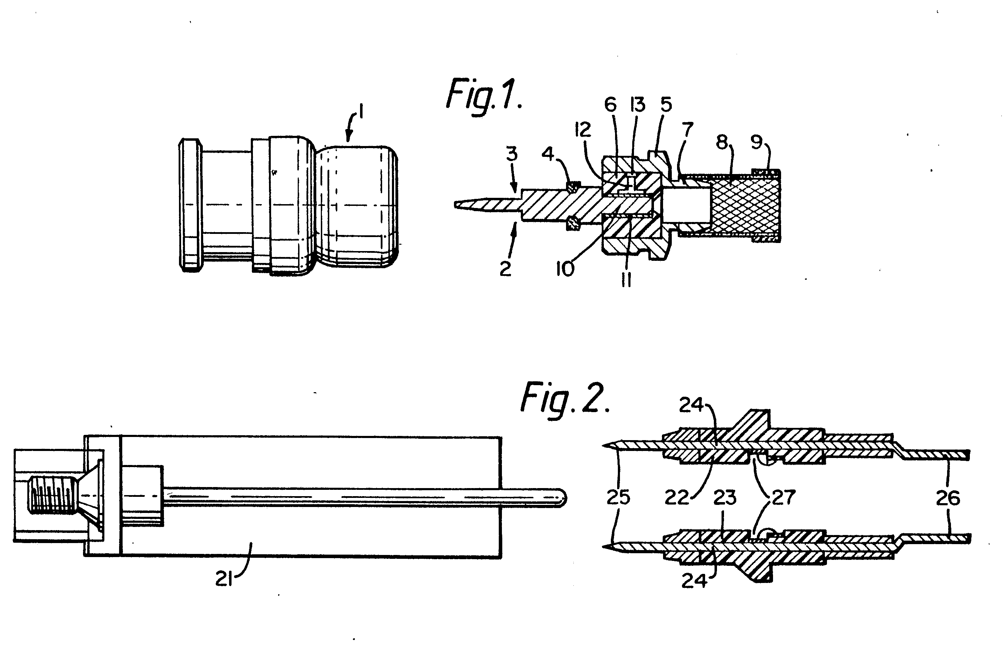

Referring to figure 1 of the accompanying drawings, a connection arrangement for connecting two coaxial cables comprises a connector shell 1 and a male connector 2. The male connector 2 comprises a pin 3, the central and rear portion of which is hollow for receiving the central conductor of a coaxial cable to be connected (not shown). The pin has a fluxed solder ring 4 and a number of apertures (not shown) beneath the solder ring which communicate between the solder ring 4 and the hollow interior of the pin 3. The rear end 10 of the pin is firmly located in a connector housing 5 by means of an electrically insulating plastics spacer 6. The housing 5, which provides the electrical connection between the shields of the cables to be connected, has a termination portion 7 on which is mounted a solder impregnated braid 8 and solder ring 9.

The rear end 10 of the pin is provided on its outer surface with a 10 micrometre thick layer 11 of a selenium-germanium-arsenic glass described above that has been deposited thereon by a vapour deposition method, and the outer surface of the glass layer 11 has been provided with a thin (about 5 micrometres thick) electrode e.g. molybdenum by a d.c. sputtering method. The electrode is electrically connected to the housing 5 via a 100 nanofarad capacitor 13 by means of a column or wire 12 of solder or other suitable conductive material.

In order to connect a coaxial cable to the connector, the outer jacket, shield and dielectric are cut back by appropriate amounts and the cable inserted into the connector so that the exposed end of the internal conductor is located within the hollow interior of the
pin 3, the dielectric abuts the rear end of the spacer
6 and the exposed shield is located within the solder
impregnated braid 8.  The connector is then briefly
heated, for example by means of a hot-air gun, to fuse
the solder rings 4 and 9 and to form solder connections
between the pin 3 and central conductor and between the
braid 8 and coax cable shield.

The connector will function exactly as a standard
coaxial connector until the connected cable experiences
a voltage transient whereupon the potential difference
across the thickness of the glass layer 11 will cause
the glass to become electrically conductive and form a
closed circuit between the central conductor and the
screen.

Referring to figures 2 to 4, a mass termination
connector such as that described in British Patent No.
1,522,485 (the disclosure of which is incorporated
herein by reference) is schematically shown.

The connector comprises a connector housing 21 and
a pair of connector wafers 22 and 23 that can be
inserted into the housing.  Each wafer 22,23 has a
number of (usually 20 or 40) metallic electrical conductors 24 extending therethrough which terminate at
one end either in the form of pins 25 or complementary
"tuning fork" female contacts and at the other end in
the form of contacts 26 for connection to a flat cable
or to a number of small single conductor wires.  The
particular means used for connecting the conductors 24
to the wires or flat cable is not shown but usually
comprises one or more solder devices as described in
U.S. Patent Specification No. 3,852,517.

In each of the wafers 22 and 23 a stepped recess 27 is made that extends across the width of the entire wafer to expose each of the conductors. in one embodiment of this connector, a 10 micrometre thick layer 28 of the selenium-germanium-arsenic glass described above is deposited onto the individual conductors 24 and a thin electrode 29 formed e.g. from molybdenum, optionally together with gold or aluminium is deposited on top of the glass layer 28. An additional conductive layer 30 or "ground plane" of gold or aluminium is deposited on the wafer material in the stepped recess 27, the ground plane being electrically earthed for example to the metallic housing of the connector or to an earth pin. Each electrode 29 is connected to the ground plane by means of a wire 31 formed from e.g. gold or aluminium and bonded to the electrode 29 and ground plane 30 by conventional wire bonding techniques.

Alternatively, a single layer 28 of the glass and electrode 29 may be deposited accross the entire width of the wafer in which case only a single wire 31 is necessary for connection to the ground plane.

In an alternative construction, the selenium-germanium-arsenic glass layer and electrodes are deposited onto the common ground plane 30, and the wires 31 connect the conductors 24, after any appropriate surface preparation if necessary, with the electrode of the glass layer.

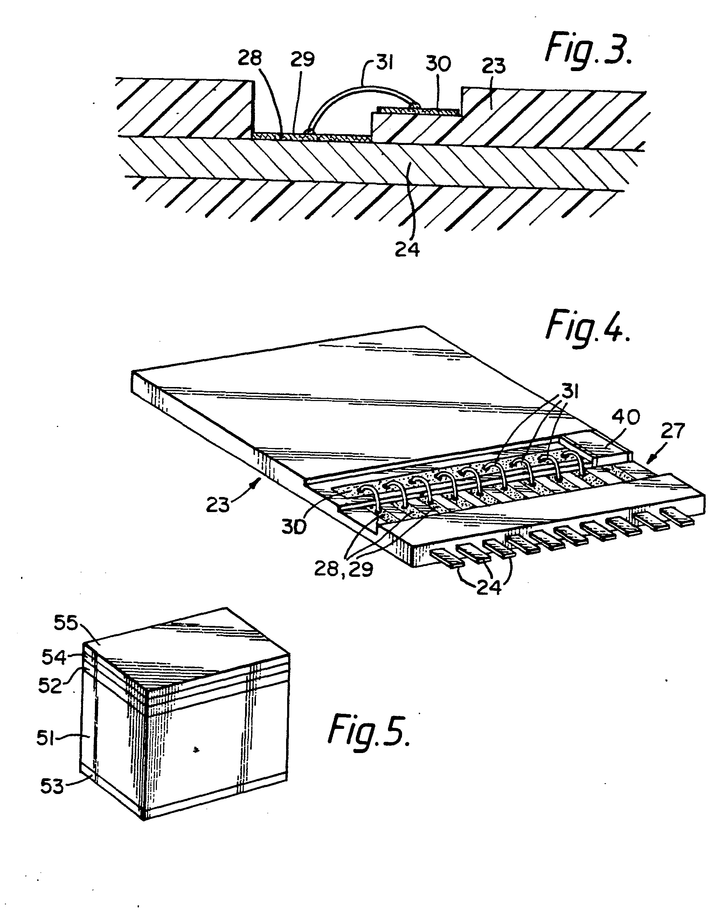

As shown in figure 4, a 100 nanofarad capacitor 40 is located in the recess 27 and is connected between the ground plane and an earth terminal or housing of the connector.  In operation, any transient having a
frequency spectrum above about 1 MHz is conducted
directly to earth while any direct currents or alternating currents of frequencies significantly lower than
about 1 MHz are blocked by the capacitor.

Figure 5 shows schematically a circuit protection
device according to the invention that may be incorporated into any larger electrical component.  The
device comprises a capacitor 51 having a capacitance
for example of 0.5 to 3 microfarads (although larger or
smaller capacitances e.g. 0.1 to 1 microfarads may be
desired in many circumstances) which is provided with
terminals 52 and 53.  A 10 micrometre thick layer 54 of
the selenium-germanium-arsenic glass switching material
described above is deposited on the terminal 52 for
example by a vapour deposition method and then a thin
electrode 55 for example formed from molybdenum is
deposited on the glass layer 54 e.g. by a d.c. sputtering technique.  Additional metal layers may be provided on top of the electrode 55 in order to improve
the formation of solder joints if desired.  As
described above, the glass layer will become conductive
when the circuit is exposed to a transient having a
high frequency spectrum, e.g. above 1 MHz, to allow the
transient to be passed to earth, but the capacitor will
exhibit a high impedance to lower frequency signals and
therefore prevent such signals latching the glass layer
54 in its low resistance state.

CLAIMS:

1.      A device for protecting an electrical circuit
from a voltage transient, which comprises a semiconductor threshold switching element that is connected, or
arranged to be connected, between a current carrying
line of the circuit and earth, and a capacitor connected in series with the threshold switching element
between the threshold switching element and earth.

2.      A device as claimed in claim 1, wherein the
capacitor has a capacitance of at least 10 nanofarads
preferably at least 100 nanofarads.

3.      A device as claimed in claim 1 or claim 3,
wherein the capacitor has a capacitance of not more
than 1 microfarad and preferably not more than 0.5
microfarads.

4.      A device as claimed in any one of claims 1 to 3,
wherein the switching element has a turn-on time of not
more than 1 nanoseconds.

5.      A device as claimed in any one of claims 1 to 4,
wherein the switching element has a latching energy of
at least 20 mJ and preferably at least 40 mJ.

6.      A device as claimed in any one of claims 1 to 5,
wherein the switching element has a critical switching
field strength from $10^4$ to $10^5$ Vcm$^{-1}$.

7.      A device as claimed in any one of claims 1 to 6,
which includes a device, connected in series with the switching element, that will exhibit a high resistance if the switching element becomes permanently electrically conducting.

8.    A device as claimed in any one of claims 1 to 7, wherein the switching element comprises a chalcogenide glass.

9.    A device as claimed in claim 8, wherein the switching element comprises an amorphous composition comprising germanium, selenium and arsenic.

10.    An electrical circuit which includes a current carrying line, the circuit being protected from an electrical surge by means of a threshold switching device connected between the current carrying line and earth, and a capacitor connected in series with the threshold switching element between the threshold switching element and earth.

11.    A circuit protection arrangement for protecting an electrical circuit that contains a plurality of current carrying lines from a voltage transient, which arrangement comprises a plurality of semiconductor threshold switching elements, each such switching element being connected, or arranged to be connected, between an individual current carrying line and earth via a common capacitor that is connected in series between each of the switching elements and earth.

12.    An arrangement as claimed in claim 11, wherein each switching element comprises a chalcogenide glass.

13.    An arrangement as claimed in claim 11 or claim 12, wherein the capacitor has a capacitance of at least 100 nanofarads.

14.     An arrangement as claimed in any one of claims 11 to 13, wherein the capacitor has a capacitance of not more than 1 microfarad.

15.     An arrangement as claimed in any one of claims 11 to 13, wherein each switching element comprises a chalcogenide glass.

16.     An arrangement as claimed in claim 15, wherein each switching element comprises an amorphous composition comprising germanium, arsenic and selenium.

********

Fig.1.

Fig.2.

**Fig.3.**

**Fig.4.**

**Fig.5.**

European Patent Office

**EUROPEAN SEARCH REPORT**

Application number

EP 86 30 2326

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 558 830 (BENDER)<br>* Figure 2; column 4, lines 45-67 * | 1,10 | H 02 H    9/04<br>H 01 L   45/00 |
| Y | | 8,9 | |
| D,Y | DE-A-1 437 387 (DANFOSS)<br>* Figures 1,2; claims 1-3 * | 8 | |
| Y | APPLIED PHYSICS LETTERS, vol. 19, no. 7, 1st October 1971, pages 221-223; R. PINTO et al.: "Electric field induced memory switching in thin films of the chalcogenide system Ge-As-Se"<br>* Page 222, left-hand column, lines 9-13 * | 9 | |
| A | US-A-3 343 085 (OVSHINSKY)<br>* Figure 7; column 9, line 59 - column 10, line 2 * | 1,8-10 | TECHNICAL FIELDS SEARCHED (Int. Cl.4)<br><br>H 02 H<br>H 01 L<br>G 03 C |
| D,A | US-A-3 343 034 (OVSHINSKY)<br>* Figure 8; column 10, lines 54-71 * | 1,8-10 | |

The present search report has been drawn up for all claims

| Place of search | Date of completion of the search | Examiner |
|---|---|---|
| THE HAGUE | 20-06-1986 | KOLBE W.H. |